(19) Europäisches Patentamt
European Patent Office
Office européen des brevets

(11) **EP 2 599 902 A1**

(12) **EUROPEAN PATENT APPLICATION**
published in accordance with Art. 153(4) EPC

(43) Date of publication:
**05.06.2013 Bulletin 2013/23**

(51) Int Cl.:
*D01F 9/127* (2006.01)     *C01B 31/02* (2006.01)
*C08K 7/06* (2006.01)     *C08L 101/00* (2006.01)

(21) Application number: **11812633.3**

(22) Date of filing: **29.07.2011**

(86) International application number:
**PCT/JP2011/067503**

(87) International publication number:
**WO 2012/015044 (02.02.2012 Gazette 2012/05)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.07.2010 JP 2010171235**

(71) Applicant: **Hodogaya Chemical Co., Ltd.**
**Tokyo 104-0028 (JP)**

(72) Inventors:
• **HITOE, Yoshinori**
**Tokyo 104-0028 (JP)**

• **SUZUKI, Jun**
**Koriyama-shi**
**Fukushima 963-8802 (JP)**
• **SATO, Hiroshi**
**Tokyo 104-0028 (JP)**
• **KAWASHIMA, Shoji**
**Tokyo 104-0028 (JP)**

(74) Representative: **Müller-Boré & Partner**
**Patentanwälte**
**Grafinger Straße 2**
**81671 München (DE)**

(54) **VAPOR GROWN CARBON FIBER AGGREGATE**

(57)     [Problems] To provide a vapor-grown carbon fiber aggregate, wherein the carbon fiber has a structure of two or more tubular graphene layers and of which the central portion in cross section of the fiber is hollow, has a little unevenness in the structure and exhibits excellent electric conductivity.

    [Means for Solution] A vapor-grown carbon fiber aggregate, wherein the carbon fiber has a structure of two or more tubular graphene layers and of which the central portion in cross section of the fiber is hollow, the average outer fiber diameter of the carbon fibers is from 10 to 300 nm, and not less than 70% of the whole number of the carbon fibers have hollow diameters of from 2 to 20 nm and hollow diameter/outer fiber diameter ratios of from 1.4 to 20%.

Fig. 7

(SECONDARY PRODUCT)

**Description**

Technical Field:

This invention relates to a vapor-grown carbon fiber aggregate and, more specifically, to a vapor-grown carbon fiber aggregate having a structure of two or more tubular graphene layers and of which the central part in cross section of the fiber is hollow.

Background Art:

Owing to their properties such as excellent dynamic properties, high electric conductivity and high thermal conductivity, carbon fibers have heretofore been widely used as filler materials being added to various kinds of matrixes to improve their properties.

In recent years, further, it has been desired to provide various materials having more improved properties meeting their use. For example, for the composite materials obtained by dispersing a carbon fiber in a matrix of an organic material as represented by a resin or of an inorganic material such as ceramics or a metal, it has been desired to provide additives capable of greatly improving such properties as electric property, mechanical property and thermal property without deteriorating properties inherent in the matrix. It has, further, been desired to provide additives capable of improving properties of liquids such as fuel oils and lubricating oils.

As the carbon fibers, fine carbon fibers such as carbon nano-aggregates as represented by carbon nanotubes are now drawing attention in a variety of fields.

A graphite layer that constitutes the carbon nanotube, usually, has a regularly arranged six-membered ring structure. Resulted from the graphite layer, therefore, the carbon nanotubes exhibit a singular electric property as well as chemically, mechanically and thermally stable properties. Therefore, it has been expected to utilize the properties of the carbon nanotubes by homogeneously dispersing the carbon nanotubes in the above-mentioned various matrixes, the fuel oils and the lubricating oils.

The key theme is how to synthesize in large amounts the carbon nanotubes that easily, stably and homogeneously disperse in various kinds of materials, and a variety of related technologies have been proposed. However, it is difficult to control parameters such as thickness (outer diameter) and hollow diameter of the carbon nanotubes. Due to the fluctuation of the parameters, therefore, the carbon nanotubes that are excellently dispersed as described above have not yet been synthesized in large amounts.

A patent document 1 is disclosing carbon fibrils having a fiber outer diameter of 3.5 to 70 nm and a hollow structure, which are entangled together to form aggregates. The aggregates formed with the carbon fibrils have the longest diameter of 0.10 to 0.25 mm. The patent document 1 is also disclosing a resin composition obtained by dispersing the aggregates of carbon fibrils in a resin.

In the resin composition of the patent document 1, the aggregates of carbon fibrils which are entangled together are dispersed in the resin matrix and, therefore, the carbon fibrils can be dispersed relatively homogeneously. According to the patent document 1, however, the aggregates of carbon fibrils are obtained by treating the carbon fibrils by applying a shearing force thereto by using, for example, a vibration ball mill. Therefore, the aggregates of carbon fibrils have a high bulk density and are not suited for efficiently improving properties such as electric conductivity by the addition thereof in small amounts.

A patent document 2 discloses a fine carbon fiber having a multi-layer structure in which tubular carbon layers are overlapped like annual rings. The fine carbon fiber is hollow at the central part of the fiber, and the carbon layers are partly failing to assume a complete tubular shape and are partly interrupted or are extending discretely. Besides, the outer diameter and the hollow diameter of the fine carbon fiber are not uniform in the lengthwise direction, the surface of the fiber is not smooth, the outer diameter is from 1 nm to 80 nm, and the aspect ratio is from 10 to 30,000.

A patent document 3 reports a fine carbon fiber of a diameter of less than 100 nm constituted by a plurality of tubular nested graphenes, the tubular graphenes having a roughly polygonal shape in cross section of the fiber.

A patent document 4 describes a vapor-grown carbon fiber of a laminate of graphenes, the C-axis of graphenes having an angle of not less than 45° but less than 90° relative to the fiber axis of the carbon fiber.

The carbon fibers disclosed in the above patent documents 2 to 4 have a significant degree of unevenness in their structures.

For example, the carbon fiber of the patent document 2 has the outer diameter and hollow diameter which are not uniform and, further, has a fiber surface which is not smooth.

Further, the carbon fibers of the patent documents 3 and 4 have irregular structures in which the tubular graphene layers are not in parallel with the center axis of the hollow space surrounded by the graphene layers.

Namely, the carbon fibers of the patent documents 2 to 4 all have irregular structures or shapes. Therefore, it is clear that the carbon fibers have a significant degree of unevenness in their structures.

In general, carbon fibers (or carbon nanotubes) having a hollow structure and comprising tubular graphene layers are produced by a vapor-phase growth method in which a carbon source gas such as hydrocarbon gas is reacted at a high temperature in the presence of a particulate metal catalyst. In the reaction, first, a graphene layer located on the center of the fiber extends and grows in a tubular shape in a manner of surrounding metal catalyst particles. Namely, the hollow space is formed by the graphene layer, and the direction in which the graphene layer extends becomes the direction of axis of the fiber. After the graphene layer at the central portion has grown as described above, a graphene layer newly grows on the outer side of the graphene layer. Thus, there is formed a multi-layer structure of tubular graphene layers.

In the carbon fibers of the patent documents 2 to 4, tubular graphene layers are not stably growing from the metal catalyst particles maintaining a nearly constant hollow diameter. As a result, the tubular graphene layers are interrupted on the way or grow discretely. Besides, graphene layers are newly formed on the outer side of the irregularly formed graphene layers and, after all, it is considered the structure becomes irregular.

Prior Art Documents:

Patent Documents]

Patent document 1:    U.S. Patent No. 5165909
Patent document 2:    Japanese Patent No. 3841684
Patent document 3:    JP-A-2006-176373
Patent document 4:    JP-A-2004-3092

Outline of the Invention:

Problems that the Invention is to Solve:

Therefore, the object of the present invention is to provide a vapor-grown carbon fiber aggregate having a structure of two or more tubular graphene layers, of which the central portion in cross section of the fiber is hollow, having a little unevenness in the structure and exhibiting excellent electric conductivity, and to provide the producing method of the same.

Means for Solving the Problems:

The present inventors have conducted a keen study about the vapor-grown fiber aggregates, have discovered that a carbon fiber aggregate having little unevenness in the structure and having excellent electric conductivity can be obtained by using a ingredient gas of which the composition satisfying predetermined conditions and by introducing the ingredient gas into the reaction region under predetermined conditions, and have, thus, completed the invention.

Namely, according to the present invention, there is provided a vapor-grown carbon fiber aggregate, wherein the carbon fiber has a structure of two or more tubular graphene layers and of which the central portion in cross section of the fiber is hollow, the average outer fiber diameter of the carbon fibers is from 10 to 300 nm, and not less than 70% of the whole number of the carbon fibers have hollow diameters of from 2 to 20 nm and hollow diameter/outer fiber diameter ratios of from 1.4 to 20%.

In the vapor-grown carbon fiber aggregate of the present invention, it is desired that:

(1) The graphene layers that constitute the carbon fibers are formed in parallel with the axis of the fibers;
(2) The average outer fiber diameter of the carbon fibers is from 50 to 300 nm, and not less than 80% of the whole number of the carbon fibers has hollow diameters and hollow diameter/outer fiber diameter ratios in the above-mentioned ranges; and
(3) The average outer fiber diameter of the carbon fibers is from 90 to 300 nm, and not less than 95% of the whole number of the carbon fibers has hollow diameters and hollow diameter/outer fiber diameter ratios in the above-mentioned ranges.

According to the present invention, further, there is provided a method of producing the vapor-grown carbon fiber aggregate comprising the steps of:

preparing an ingredient gas by mixing a carbon source, a catalyst source and a promotor into a hydrogen gas, wherein the carbon source contains methane, benzene and toluene, the catalyst source comprises ferrocene and the promotor comprises thiophene;

introducing the ingredient gas into a reactor;

forming a defective carbon fiber aggregate that is formed from patch layers, the patch layers are patchily deposited by thermally decomposed carbon atoms on the outer circumferential surfaces of tubular graphene layers, by introducing the ingredient gas into the reactor passing from a first reaction region to a second reaction region of the reactor, wherein the temperature of the second reaction region is set to be higher than that of the first reaction region; and

taking out the defective carbon fibers from the reactor followed by a heat treatment in an inert gas atmosphere to remove impurities and to convert the patched layers into tubular graphene layers by recrystallization;

wherein the ingredient gas has a toluene/methane mol ratio of from 0.05 to 10, a toluene/benzene mol ratio of from 0.1 to 100, and a hydrogen content of not less than 70% by volume, and contains the ferrocene in an amount of from 1.0 to 10% and the thiophene in an amount of more than 0.5% but not more than 2.0% on the mass basis of toluene;

the ingredient gas is introduced at a temperature of not higher than 400°C into the reactor; and

the first reaction region is set at 700 to 900°C, and the second reaction region is set at 800 to 1300°C on condition that the temperature therein is higher than the temperature in the first reaction region.

In the above production method, it is desired that:

(1) The defective carbon fiber aggregate is heat-treated through a low-temperature firing at 800 to 1200°C and a high-temperature firing at 2000 to 3000°C following the low-temperature firing; and
(2) The ingredient gas is introduced into the first reaction region in a turbulently flowing manner.

According to the present invention, further, there is provided a composite material in which the above vapor-grown carbon fiber aggregate is dispersed in a matrix of at least one material selected from a resin, ceramics and a metal.

Effects of the Invention:

The vapor-grown carbon fiber aggregate of the present invention has an average outer fiber diameter in a range of from 10 to 300 nm, preferably, from 50 to 300 nm and, more preferably, from 90 to 300 nm , i.e., the thickness reaches a predetermined level. Here, what is particularly important is that the formed fibers have a very small unevenness in the structure thereof, and hollow diameters and ratios of hollow diameter to outer diameter that are lying in very limited ranges. Namely, in the fiber aggregate of the invention, not less than 70%, preferably, not less than 80% and, most preferably, not less than 95% of the whole number of the carbon fibers (hereinafter referred to as main fibers) have hollow diameters of from 2 to 20 nm and a ratio of hollow diameter to outer diameter of fibers of from 1. 4 to 20%. In effect, most of the vapor-grown carbon fibers forming the fiber aggregate of the invention are the main fibers mentioned above. Therefore, the aggregate of the invention has a very small fluctuation in the properties and, besides, can be easily and homogeneously dispersed in a matrix such as resin, metal or ceramics yet featuring excellent dispersion stability. Accordingly, upon being dispersed in various kinds of matrixes, the vapor-grown carbon fiber aggregate of the invention works to effectively improve their electric conductivity and dynamic properties, the improvement being attained with little fluctuation.

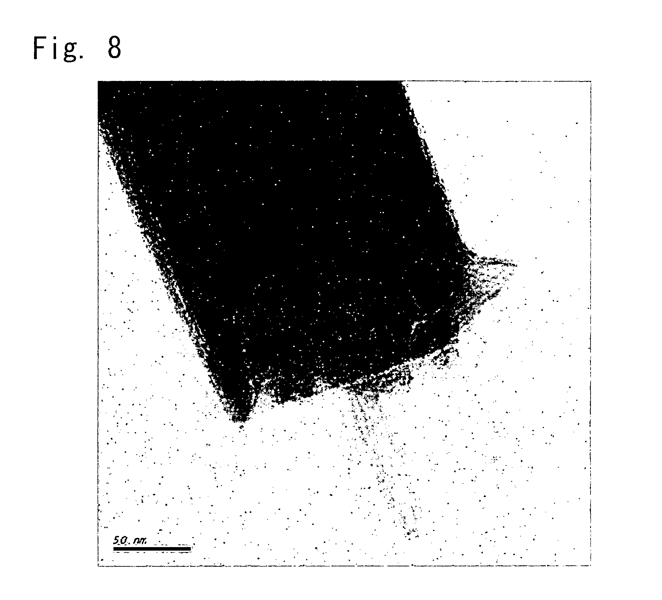

Further, the main fibers have very small hollow diameters as compared to the outer fiber diameters. Therefore, the aggregate exhibits not only excellent electric conductivity but also effectively alleviates the bad influences stemming from that the carbon fibers possess the hollow structure. For example, when the carbon fibers are dispersed in various matrixes, powerful energy of dispersion is applied to the carbon fibers making the carbon fibers to be broken easily. The broken carbon fibers have their ends opened (open end)(see Fig. 8); i. e. , the hollow spaces of the fibers are opened and, as a result, the matrix infiltrates into the hollow spaces. Therefore, when the carbon fiber aggregate is used as an electrode material of a lithium battery, lithium ions are adsorbed by the inner wall surfaces of the carbon fibers, and the adsorbed lithium ions no longer contribute to the charge or discharge of the battery resulting in a decrease in the discharge capacity of the battery. According to the present invention, on the other hand, most of the carbon fibers forming the vapor-grown carbon fiber aggregate are the main fibers having small hollow diameters. Even if the fibers are broken, therefore, the areas of the inner walls of the fibers remain small, the adsorption of lithium ions is able to be effectively suppressed. It will thus be learned that the vapor-grown carbon fiber aggregate of the invention can be favorably used as an electrode material of the lithium batteries.

According to the present invention, further, the carbon fiber aggregate is produced by using an ingredient gas that contains a predetermined carbon source gas, a catalyst source gas, a promotor source gas and a carrier gas, reacting the ingredient gas at a high temperature in a reactor, and heat-treating the obtained defective carbon fiber aggregate. Here, specifically, the composition of the ingredient gas and the temperature of introducing the ingredient gas into the reactor are so set as to satisfy predetermined conditions, so that the metal catalyst particles are stably and homogeneously distributed in the furnace. As a result, there is produced the vapor-grown carbon fiber aggregate which comprises mostly the main fibers having little unevenness in the structure and having small hollow diameters as described above.

Brief Description of the Drawings:

[Fig. 1] is a view schematically illustrating the structure of a reactor used for producing vapor-grown carbon fibers of the present invention.
[Fig. 2] is a view showing the distributions of a carbon source (hydrocarbons) and a catalyst of when no gas flow-adjusting member is installed in the reactor of Fig. 1.
[Fig. 3] is a view showing a fluidized state of an ingredient gas discharged from an introduction nozzle of the reactor shown in Fig. 1.
[Fig. 4] is a view showing the distributions of the carbon source (hydrocarbons) and the catalyst of the ingredient gas in Fig. 3.
[Fig. 5] is a view showing, on an enlarged scale, a gas introduction portion of the reactor of the Fig. 1.
[Fig. 6] is a schematic view and a TEM photograph of an intermediate-product fiber (defective carbon fiber) formed in producing the vapor-grown carbon fiber aggregate of the present invention.
[Fig. 7] is a schematic view and a TEM photograph of a carbon fiber for forming the vapor-grown carbon fiber aggregate of the present invention.
[Fig. 8] is a TEM photograph showing an opening structure of when a vapor-grown carbon fiber is cut.

Mode for Carrying Out the Invention:

The vapor-grown carbon fiber aggregate of the invention is produced by the CVD (chemical vapor deposition) method by using a floating catalyst. Namely, an ingredient gas containing a predetermined carbon source and a catalyst source is introduced into a reactor of a predetermined structure, and is passed through a first reaction region and a second reaction region in a state that the metal catalyst particles are deposited from the ingredient gas, whereby defective carbon fibers, i.e., intermediate product, are formed and are then heat-treated at a high temperature to produce a vapor-grown carbon fiber aggregate of the invention which is free of structural defect.

<Ingredient gas>

The present invention uses, as the ingredient gas, a mixed gas obtained by mixing a carbon source, a catalyst source and a promotor source into a hydrogen gas (carrier gas). The ingredient gas must be strictly controlled for its kind and amount of use to obtain a carbon fiber aggregate having small unevenness in the structure thereof.

As the carbon source, there can be used methane, benzene and toluene. Namely, by reacting (thermally decomposing) these hydrocarbons at a high temperature in the presence of a catalyst and a promotor, there can be deposited graphene layers that constitute carbon fibers.
That is, among the three kinds of hydrocarbons, if only one or two kinds of them are used as a carbon source, it is unable to obtain a vapor-grown carbon fiber aggregate containing much main fibers having small hollow diameters as compared to the outer diameters of fibers. For example, when only the toluene is used as a carbon source, the ratio of the hollow diameter to the outer diameter of fibers becomes more than 20% and the proportion of the main fibers in the fiber aggregate becomes less than 50%, and the structure becomes uneven very greatly therefore as demonstrated in Comparative Example 1 mentioned later. No doubt, when the other kinds of carbon source except the above are used, too, it is unable to obtain the desired carbon fiber aggregate containing much main fiber.

In the invention, the composition of the carbon source is such that the mol ratio of toluene/methane is from 0.05 to 10, preferably, from 0.1 to 5.0 and, more preferably, from 0.15 to 1.0, and the mol ratio of toluene/benzene is from 0.1 to 100, preferably, from 0.5 to 50 and, more preferably, from 1.0 to 20. That is, if the composition of the carbon source is out of the above range, fluctuation occurs in the temperature regions in which each hydrocarbon thermally decomposes and, as a result, it becomes difficult to obtain the desired carbon fiber aggregate having small unevenness in the structure.

Here, the outer diameters of the obtained carbon fibers can be adjusted depending upon the concentration of the carbon source contained in the ingredient gas. For example, the outer diameters of the carbon fibers can be increased by increasing the concentration of the carbon source.

The present invention uses a ferrocene as the catalyst source. That is, upon being heated in the reactor as will be described later, iron particles are formed from the ferrocene and work as a catalyst. With the iron particles as starting points, graphene layers grow to form the desired vapor-grown carbon fibers having tubular graphene layers. In the invention, the content of the catalyst source (ferrocene) gas contained in the ingredient gas should be in a range of from 1.0 to 10% by mass per the toluene. Depending upon the concentration of the catalyst source, too, the outer diameters of the obtained carbon fibers can be adjusted. Upon increasing the concentration of the catalyst source, for instance, the catalyst metal (iron) particles are formed in an increased number in the reactor, and the outer diameters of the obtained carbon fibers become small.

Further, a thiophene is used as the promotor. Namely, upon being heated in the reactor, the promotor source is decomposed to form sulfur that works as a promotor for iron particles. During the thermal decomposition of the above hydrocarbons (methane, benzene and toluene), if sulfur exists in a suitable amount together with the iron particles, then the carbon atoms formed by the thermal decomposition of hydrocarbons are easily taken into the iron catalyst particles whereby the carbon atoms are recrystallized by the catalytic action of the iron particles, and the fiber structure (structure of a multilayer tubular graphene layers) is efficiently formed.

If no sulfur exists, the carbon atoms are little taken into the catalyst particles whereby non-fibrous material increases making it difficult to obtain the carbon fiber aggregate containing much main fibers having small hollow diameters. Here, sulfur acts to decrease the surface tension of iron. Therefore, if sulfur exists in large quantity, the surface tension of the iron particles decreases. As a result, the diameter of the formed iron catalyst particles becomes excessively large to result in an increase in the hollow diameter of the obtained carbon fibers. From the above point of view, therefore, the thiophene used as the promotor should be contained in the ingredient gas in an amount more than 0.5% by mass but not more than 2% by mass per the toluene.

The ingredient gas, further, contains a hydrogen gas as a carrier gas in addition to containing the above carbon source, catalyst source and promotor source. The hydrogen gas is contained in the ingredient gas in an amount of not less than 70% on the volume basis. Use of the hydrogen gas as the carrier gas makes it possible to obtain the desired vapor-grown carbon fibers in high yields.

The ingredient gas of the above-mentioned composition introduced into the reactor undergoes the reaction in a first reaction region and in a second reaction region in the reactor, and there is obtained an intermediate-product fiber having graphene layer grown in a tubular shape with the catalyst particles as ingredient points. Here, the intermediate-product fiber is a defective carbon fiber of which the graphene layer on the outer side has not been grown to a complete tubular form. Namely, in the defective carbon fiber obtained in this step, the graphene layer on the outer side is a patch layer in which the graphenes are deposited in a patched manner and patch-like sheets are stuck thereto. Therefore, the defective carbon fiber aggregate is taken out from the reactor and is introduced into the next step of heat treatment where impurities are removed and the patch layer on the outer side is converted into a tubular graphene layer by recrystallizing the carbon atoms in order to obtain the vapor-grown carbon fiber aggregate of the present invention free of structural defect.

<Structure of the reactor>

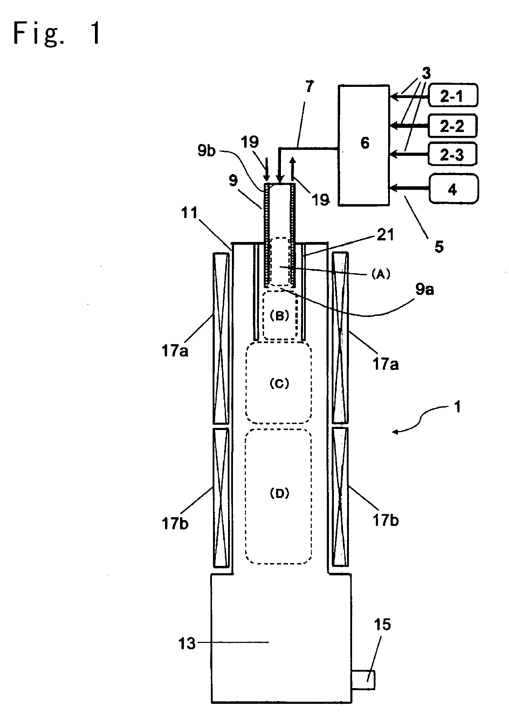

The reactor used for the reaction is made of heat-resistant ceramics such as a sintered body of silicon carbide having a small porosity and a high thermal conductivity, and has a structure as shown, for example, in Fig. 1. The ingredient gas of the composition mentioned above is introduced into the reactor generally designated at 1, and a predetermined reaction is conducted.

Namely, three kinds of hydrocarbons, i.e., methane, benzene and toluene respectively contained in carbon source tanks 2-1 to 2-3, are introduced into an evaporator 6 at amount ratios in predetermined ranges as described above through pipes 3 and, at the same time, a hydrogen gas contained in a carrier gas tank 4 is introduced into the evaporator 6 through a pipe 5 so as to satisfy the predetermined amount ratios.

In the carbon source tank 2-3 containing toluene, a catalyst source (ferrocene) and a promotor (thiophene) have been mixed so that the amount ratios thereof per toluene lies in the above-mentioned ranges. The catalyst source and the promotor source are introduced together with toluene into the evaporator 6.

The evaporator 6 is heated and maintained at a temperature of about 350 to about 400°C and in which the catalyst source (ferrocene) and the promotor source (thiophene) are vaporized together with the each carbon source to prepare the ingredient gas of the composition described above.

Unevenness in the composition of the ingredient gas causes unevenness in the hollow diameter of the obtained carbon fibers and unevenness in the outer diameter of the carbon fibers. To prevent unevenness in the composition of the ingredient gas, therefore, it is desired to provide a stirrer such as propeller or the like in the evaporator 6.

The ingredient gas prepared in the evaporator 6 is introduced into the reactor 1 through a gas introduction pipe 7.

As will be understood from Fig. 1, the reactor 1 as a whole has a cylindrical structure, and includes an introduction nozzle 9, a straight body portion 11 and a fiber recovery chamber 13 connected to the lower end of the straight body portion 11. A gas discharge pipe 15 is connected to the fiber recovery chamber 13.

The outer surface of the straight body portion 11 is surrounded by an upper heater 17a and a lower heater 17b, and the upper portion and lower portion of the straight body portion 11 are separately heated by these heaters 17a and 17b.

The above introduction nozzle 9 is inserted in an upper space (portion surrounded by the upper heater 17a) of the straight body portion 11, and a discharge port 9a of the nozzle 9 is extending into the straight body portion 11. Further, the introduction nozzle 9 is provided on the outer surface thereof with a cooling jacket. A cooling gas 19 (cooling air or cooling nitrogen gas) is fed to the jacket to circulate therein, and the ingredient gas introduced into the straight body portion 11 is cooled down to a suitable temperature in the introduction nozzle 9.

Further, the ceiling wall of the straight body portion 11 is provided with a tubular gas flow-adjusting member 21 so as to surround the introduction nozzle 9 that is inserted. The gas flow-adjusting member establishes a turbulent state in which a flow of the ingredient gas introduced into the straight body portion 11 is effectively stirred.

In the reactor 1 of the above structure, the four regions (A) to (D) are formed in the straight body portion 11 depending upon the temperature distribution created when the upper space and the lower space in the straight body portion 11 are heated by the heaters 17a and 17b.

That is, the regions (A) to (C) are those regions heated by the upper heater 17a. Among these regions, the region (A) is an inner space of the introduction nozzle 9 and is located inside the straight body portion 11. That is, being positively cooled by the cooling jacket provided for the introduction nozzle 9, the reactor temperature in the region (A) is higher than the temperature of the inner space of the nozzle 9 located outside the straight body portion 11 but is the lowest as compared to other regions (B) to (D), and is, for example, not higher than 420°C.

The region (B) is a space from the discharge port 9a of the introduction nozzle 9 down to the lower end of the gas flow-adjusting member 21. In the region (B), heating by the heater 17a is moderated by the gas flow-adjusting member 21. The reactor temperature in the region (B), therefore, is higher than the temperature in the region (A) but is lower than in the regions (C) and (D) that will be described below, and is, usually, not higher than 700°C.

The region (C) is a space that pertains to the upper space heated by the heater 17a but is lower than the lower end of the gas flow-adjusting member 21, and represents a first reaction region. The region (C) is provided with no member for suppressing the heating by the heater 17a and, therefore, the reactor temperature therein is high and is, usually, set to be from 700 to 900°C.

The region (D) is the lower space in the straight body portion 11 heated by the heater 17b, and represents a second reaction region. The reactor temperature in the region (D) is set to be from 800 to 1300°C on condition that the temperature therein is higher than the temperature in the region (C).

The ingredient gas is introduced into the reactor 1 having the above structure and the above regions, and passes through the region (A) and the region (B), undergoes predetermined reactions through the regions (C) and (D) to form a defective carbon fiber aggregate which is a precursor of the desired carbon fibers, and the aggregate is trapped in the fiber recovery chamber 13 located on the lower side.

Further, waste gases containing unreacted carbon source gas and the like gas are discharged through a gas discharge pipe 15. The waste gases that are discharged are cooled through a heat exchanger or the like. As required, unreacted carbon source gas and byproducts are removed from the waste gases by means of filter, chilling (separation by condensation) or distillation. The unreacted gases that are removed are suitably reused. Further, the waste gases from which the unreacted carbon source gas and byproducts have been removed are the gases rich in hydrogen, and are suitably fed and circulated as a carrier gas into the evaporator 6.

In the process carried out in the above reactor 1, it is very important to suitably set the temperature distribution in the reactor 1 in order to obtain the vapor-grown carbon fiber aggregate of the invention in good quality and in good yield. For example, the iron which is a catalyst has such a property that the crystal structure thereof changes depending upon the temperature. In the case of pure iron, a transformation point at which the crystal structure changes from the $\alpha$-iron into the $\gamma$-iron is about 911°C. Further, though the crystal structure does not change, there exists a magnetic transformation point at about 769°C, and the iron loses magnetic property at higher than this temperature. The temperature of transformation point lowers if carbon infiltrates into iron. The crystal structure of iron is closely related to the catalytic activity, and the formed carbon structure assumes a fibrous shape or a spherical shape formed surrounding the circumferential surfaces of iron particles depending upon a difference in the crystal structure. Further, the magnetic property possessed by the iron particles takes part in the interaction among the particles and may cause the iron particles to work as catalyst particles. By taking the above properties of iron into consideration, therefore, the temperature in the reactor is suitably controlled so that the iron exhibits catalytic activity maintaining stability to thereby obtain the vapor-grown carbon fiber aggregate of the present invention comprising chiefly the main fiber having a predetermined structure with little unevenness.

The above reactor 1 uses two heaters (heaters 17a and 17b) to heat the interior of the straight body portion 11, but may use many more heaters to effect the heating more evenly.

Processes conducted in the reactor 1 will now be described with reference to the accompanying drawings.

Step of introducing the ingredient gas into the reactor 1:

The ingredient gas prepared by mixing and stirring in the evaporator 6 is introduced into the reactor 1 through the gas introduction pipe 7. Namely, the gas introduction pipe 7 is connected to the introduction nozzle 9 through which the ingredient gas is introduced into the straight body portion 11 that includes the first and second reaction regions (reaction regions (C) and (D)).

About the amount of introducing the ingredient gas, it is desired to set the flow rates of the carbon source gas and the catalyst source gas mixed into the ingredient gas depending on the size of the reactor 1 while taking into consideration the residence time of the gas in the reactor 1. For instance, subjecting to the condition that the composition of the above ingredient gas is satisfied, it is desired to set the flow rate of the ingredient gas introduced through the introduction nozzle 9 that the carbon source is introduced with an amount of from about 50 to about 5, 000 g/min/m$^2$ and the catalyst source is introduced with an amount of from about 0.5 to 500 g/min/m$^2$ into the reactor 1 per a horizontal sectional area of the straight body portion 11 of the reactor 1. From the above point of view, in general, the amount of introducing the ingredient gas is set to be from 5,000 to 20,000 NL/min/m$^2$.

Here, the present invention uses the ferrocene as a catalyst source. The ferrocene undergoes the decomposition at a high temperature and forms iron particles that work as a catalyst. By the reaction in the region (C) that will be described later, therefore, the tubular graphene layers are formed from the carbon source.

Here, the ingredient gas contains the hydrogen gas as a carrier gas, and the temperature at which the iron particles are formed from the ferrocene in the hydrogen atmosphere is slightly higher than 420°C. In order to prevent the clogging caused by the deposition of iron particles in the introduction nozzle 9, therefore, the temperature for introducing the ingredient gas into the reactor 1 (temperature at the inlet portion 9b of the nozzle 9) is set to be not higher than 400°C and, preferably, from 395 to 400°C.

To set the temperature of the ingredient gas at the inlet portion 9b of the nozzle 9 to lie in the above range, the heating temperature in the evaporator 6 may be set to be lower than 400°C or the gas introduction pipe 7 may be provided with a heat exchanger to adjust the temperature of the ingredient gas in the introduction pipe 7.

The introduction nozzle 9 is heated by the heater 17a in the upper portion of the straight body portion 11. Even when the temperature of the ingredient gas is set to be not higher than 400°C at the inlet portion 9b, therefore, the temperature of the ingredient gas in the introduction nozzle 9 (i.e., the temperature in the region (A) or at the discharge portion 9a of the nozzle 9) often exceeds 420°C and iron particles are formed by the decomposition of ferrocene to clog the introduction nozzle 9.

To solve this problem, as described above, the cooling jacket is provided surrounding the introduction nozzle 9 that is directly coupled to the reactor 1, and the temperature in the region (A) or the temperature of the ingredient gas at the discharge portion 9a of the nozzle 9 is so set by the cooling gas as will not to exceed 420°C.

Step of adjusting the flow of the ingredient gas:

In the present invention, it is desired that the ingredient gas introduced into the reactor 1 as described above passes through the region (A) of the introduction nozzle 9, is discharged from the end (discharge portion 9a) of the nozzle 9, and is introduced into the region (B) where the flow thereof is adjusted. Namely, to adjust the flow of gas, the tubular gas flow-adjusting member 21 is provided surrounding the introduction nozzle 9.

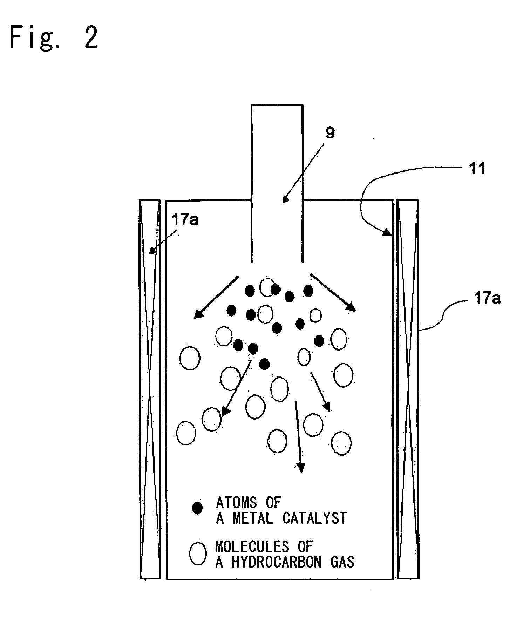

When no gas flow-adjusting member is provided, as shown in Fig. 2, the gasified compound of carbon source (hydrocarbon) rapidly expands and disperses in the reactor 1. Here, the interior of the reactor 1 has been maintained at a high temperature and the catalyst particles (Fe) are readily formed from the catalyst source (ferrocene) in the ingredient gas. However, the catalyst particles are in a solid state and their expansion·diffusion coefficient is low. Therefore, the concentration of the catalyst particles becomes locally high near the discharge portion 9a of the introduction nozzle 9. As a result, the catalyst particles collide with one another causing unevenness in the size of the catalyst particles. In the vapor-phase growth method employed by the present invention, as will be described later, the carbon fiber grows with the particles of the catalyst (Fe) as nuclei. Therefore, if the catalyst particles assume uneven sizes, the hollow diameter and outer diameter of the fibers become uneven making it difficult to obtain a carbon fiber aggregate comprising mostly the main fibers of which the hollow diameters and outer diameters are within the predetermined ranges and are varying little.

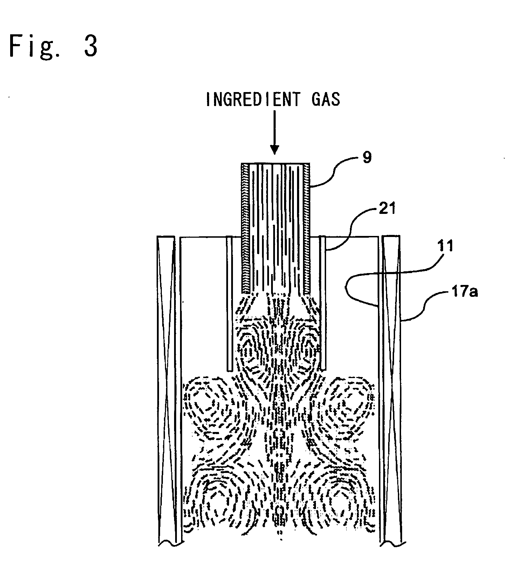

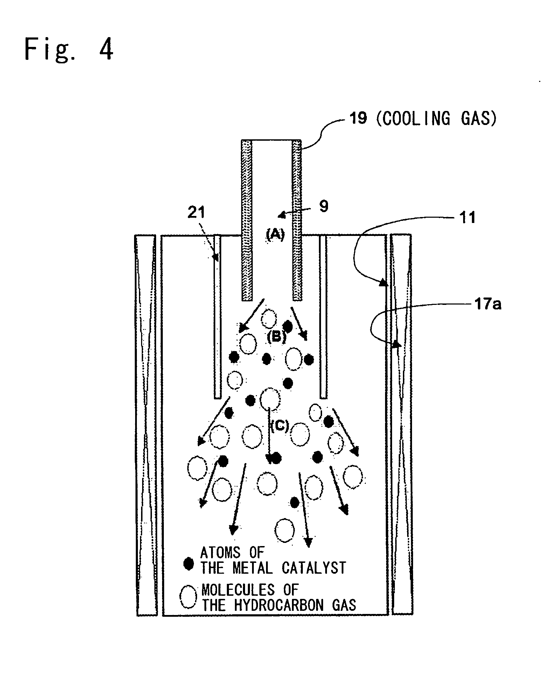

By providing the tubular gas flow-adjusting member 21 so as to surround the introduction nozzle 9 as shown in Fig. 1, on the other hand, the ingredient gas discharged from the discharge port 9a of the introduction nozzle 9 repetitively collides with the inner wall surfaces of the gas flow-adjusting member 21 as will be understood from Fig. 3 that illustrates the fluidized state of the gas flow. Therefore, the ingredient gas flows turbulently down to the lower reaction zone (area (C)) in the form of a complex flow involving eddy currents. Namely, in this case, as is obviously known from Fig. 4 that shows the distributions of the carbon source and the catalyst, the catalyst particles do not locally stay near the discharge port 9a of the introduction nozzle 9 but quickly migrate to the reaction zone of the downstream in a state in which the catalyst particles are evenly distributed together with the carbon source in the reactor 1 (straight body portion 11).

If concretely described, in the region (B) formed by the upper heater 17a and the tubular gas flow-adjusting member 21 described above, the ferrocene (catalyst source) in the ingredient gas is decomposed to form Fe atoms. Here, the Fe atoms that are being formed collide with one another due to the stirring and mixing by the gas flow and, as a result, clusters are formed each consisting of about 100 Fe atoms. In the stage of the clusters, the particles are not still crystalline and do not work as a catalyst for forming carbon fibers. In a step in which the clusters migrate to the downstream region (C), the clusters (clusters and Fe atoms) come into collision with one another to form crystalline Fe particles of an average diameter of about 5 nm to about 10 nm, and the crystalline particles work as catalyst particles.

Upon providing the gas flow-adjusting member 21 as described above, the clusters do not stay near the discharge port 9a of the introduction nozzle 9 but quickly diffuse and flow together with the carbon source repeating the collision at a high frequency and forming catalyst particles having even particle sizes. It is, therefore, made possible to more reliably obtain a carbon fiber aggregate comprising mostly the main fibers of which the hollow diameters and outer diameters are lying within predetermined ranges with little variation.

Further, the above tubular gas flow-adjusting member 21 also works as a heat buffer to suppress the heating by the upper heater 17a. Therefore, the region (B) surrounded by the gas flow-adjusting member under the introduction nozzle 9 has a temperature higher than the region (A) in the introduction nozzle 9 but lower than the lower reaction zone (i.e., region (C)). That is, upon installing the tubular gas flow-adjusting member 21, the furnace temperature in the region (B) is set to assume a temperature which is, for example, not higher than 700°C. Accordingly, the ingredient gas flowing into the straight body portion 11 from the introduction nozzle 9 is not readily heated at a high temperature (e.g., not lower than 500°C) but is gradually heated through the region (A) and the region (B), and is introduced into the first reaction region (region (C)) of a high temperature passing through the above regions. The above temperature distribution is capable of preventing the formation of carbon fibers in the tubular gas flow-adjusting member 21, and is very advantageous in obtaining the carbon fiber aggregate comprising mostly the main fibers of which the hollow diameters and outer diameters are lying within predetermined ranges with little variation.

For example, if the ingredient gas introduced into the reactor 1 is readily heated to a high temperature of not lower than 500°C, then the carbon source is thermally decomposed before the carbon source, catalyst source and promotor source in the ingredient gas are sufficiently diffused in the reactor 1, and the hollow diameters and outer diameters of the fibers tend to become uneven. Use of the tubular gas flow-adjusting member 21 is advantageous in avoiding the above inconvenience.

Presence of sulfur stemming from the promotor source lowers the surface tension of iron, permits the formed iron particles to assume large diameters, and an increase in the diameter of iron particles results in an increase in the hollow diameters of carbon fibers which are obtained. On the other hand, the surface tension of iron also varies depending on the temperature (e.g., the surface tension of iron decreases with an increase in the temperature). By adjusting the temperature in the reactor 1 depending on the amount of the promotor source that is used, therefore, it is allowed to effectively avoid an increase in the hollow diameter caused by the use of the promotor source and to form more main fibers having a ratio of the hollow diameter/outer fiber diameter lying in a predetermined range.

In the present invention, the shape of the above gas flow-adjusting member 21 is not limited to the tubular shape only provided it is capable of introducing the ingredient gas into the lower reaction zone while transforming the flow thereof into a turbulent flow that produces stirring action. The tubular shape, however, is most desired from such a standpoint that it has a temperature distribution function (heat buffering function) for reliably forming the region (B) in addition to creating the turbulent flow.

It is, further, desired that the size of the tubular gas flow-adjusting member 21 is determined depending on the velocity of flow of the ingredient gas introduced into the straight body portion 11 from the introduction nozzle 9 in addition to on the size of the introduction nozzle 9 and on the size of the straight body portion 11.

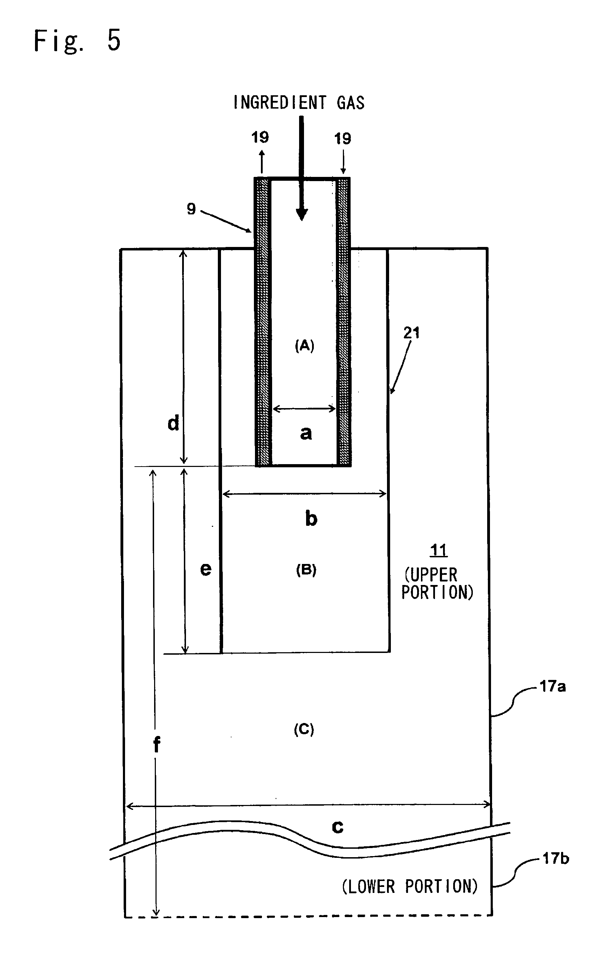

Referring to an expanded view of Fig. 5, when, for example, the rate of introducing the ingredient gas is set to lie in the above-mentioned range (5, 000 to 20, 000 NL/min/m$^2$), it is desired that the following dimensional ratio is satisfied,

a:b:c = 1: (1.1 to 3) : (2 to 5)

wherein a is the inner diameter of the introduction nozzle 9, b is the inner diameter of the gas flow-adjusting member, and c is the inner diameter of the straight body portion 11.

It is, further, desired that the following dimensional ratio is satisfied,

d:e:f = 1:(0.25 to 0.5):(4 to 9)

wherein d is a distance from the upper end of the straight body portion 11 to the discharge port 9a of the introduction nozzle 9, e is a distance from the discharge port 9a to the lower end of the gas flow-adjusting member 21, and f is a distance from the discharge port 9a to the lower end of the straight body portion 11 (lower end position of the lower heater 17b).

Thus, the turbulent flow of ingredient gas created by the action of the gas flow-adjusting member 21 flows in a complex form involving eddy currents as shown in Fig. 3 into the downstream reaction region, and the first and second reaction steps are executed.

First step of reaction:

As described above, the region (C) positioned downstream of the region (B) has been set to lie in a range of from 700 to 900°C. Into the region (C), further, there flows the ingredient gas that contains the carbon source accompanied by the Fe catalyst particles formed in the region (B) and the promotor (sulfur). As a result, the first reaction takes place in the region (C).

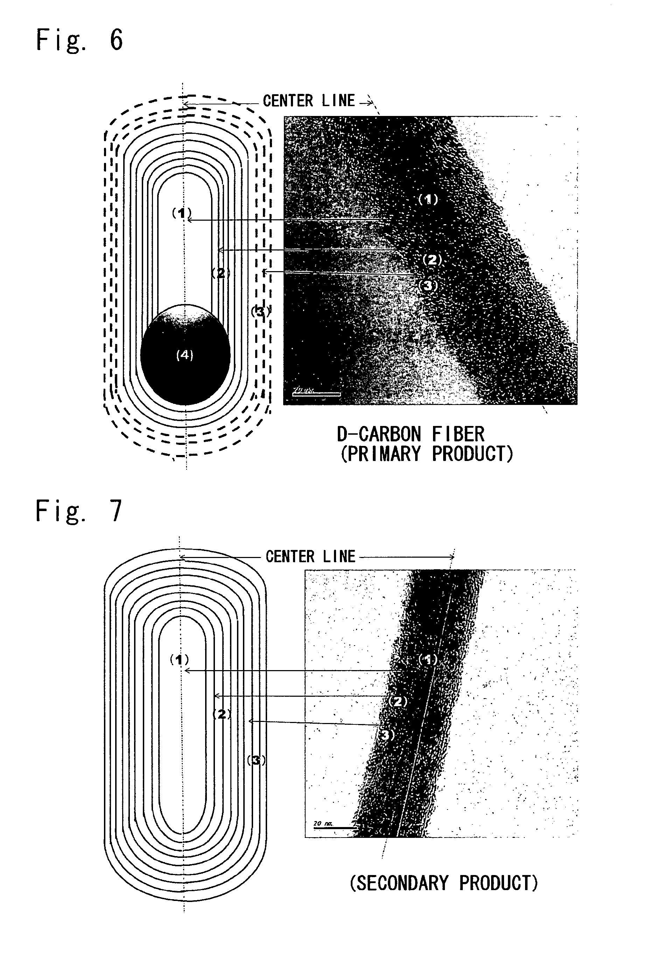

Here, in the reaction, of the carbon source, the components having low thermal decomposition temperatures (e.g., methane and benzene) are thermally decomposed on the surfaces of the catalyst particles (Fe particles) to form carbon as shown in Fig. 6. In this case, due to the presence of sulfur which is a promotor, the carbon source is more taken into the catalyst particles, and whereby the carbon is recrystallized in one direction starting from the catalyst particles (designated at (4) in Fig. 6) to form tubular graphene layers (2) (portions of solid lines) that define a hollow space (1). Namely, the carbon fiber is formed in the axial direction of fiber.

That is, the tubular graphene layers grown here constitute the inner graphene layers of the vapor-grown carbon fibers of the invention and define the hollow space at the center of the fibers. Diameter of the hollow space is referred to as the hollow diameter of the carbon fibers.

The tubular graphene layers can be formed into a single-layer structure or a multi-layer structure of two or more layers by controlling the time (i.g., velocity) for passing through the region (C).

The hollow carbon fibers formed by the above reaction extend as described above into an average length of from several microns to several tens of microns in the axial direction of the fibers, and migrate to the lower region (D) due to their own weights and the flow of the carrier gas (hydrogen gas).

Second step of reaction.

As will be understood from Fig. 1, the region (D) is a region heated by the lower heater 17b and is heated at a temperature over a range of 800 to 1300°C. That is, in the region (D), the component having a high thermally decomposing temperature (e.g., toluene) in the carbon source thermally decomposes in the gas phase, and carbon formed by the thermal decomposition accumulates on the tubular graphene layers of the hollow carbon fibers that is obtained above. As a result, patch layers (designated at broken lines (3) in Fig. 6) grow in the direction of thickness of the hollow carbon fibers and form on the tubular graphene layers (2). The patch layers have a structure in which patches of sheet are stuck, and are not forming a complete tube. Therefore, the carbon fibers obtained in this stage are defective carbon fibers having a structural defect.

As will be learned from the fact that the temperature range in the above region (C) is overlapping on the temperature region of the region (D), the region (C) and the region (D) have not been distinctly separated from each other. In a region where the temperatures are overlapping over 800 to 900°C, for example, the tubular graphene layers (2) are formed and, at the same time, the components having high thermal decomposition temperatures undergo the thermal decomposition in the gas phase to form patch layers (3) on the tubular graphene layers (2).

In principle, further, the temperature in the region (D) can be set to be lower than the temperature in the region (C). In this case, however, an ascending current occurs due to a temperature differential and, accordingly, the reaction time tends to vary in the regions (C) and (D) making it difficult to obtain homogeneous carbon fibers. To avoid the ascending current from occurring, therefore, it is desired to set the temperature in the region (D) to be higher than the temperature in the region (C).

The hollow carbon fibers comprising tubular graphene layers on which patch layers are formed as described above, fall down by their own weights and by the flow of the carrier gas (hydrogen gas), and are recovered in the lower fiber recovery chamber 13 while the unreacted gases and carrier gas are discharged from the gas discharge pipe 15.

The hollow carbon fibers recovered in the fiber recovery chamber 13 comprise, as described above, outer layers which are not tubular graphene layers but patch layers (i.e., having incomplete tubular graphene multi-layered structure), besides, contain unreacted components, nonfibrous carbides, tar component and catalyst particles (Fe particles), i.e., are defective carbon fibers. That is, the defective carbon fiber aggregate obtained in this step is a precursor of the vapor-grown carbon fiber aggregate of the invention, and must be heat-treated in the next step.

The fact that the above defective carbon fibers have an incomplete tubular graphene multi-layered structure can be confirmed by the Raman spectrometry.

Namely, the Raman spectrometry of large single crystalline graphite only expresses a peak called G-band near 1580 cm$^{-1}$. With the above defective carbon fibers, however, a peak also appears near 1360 cm$^{-1}$ in addition to the G-band. This peak is called D-band and stems from a lattice defect. It will thus be understood that the presence of an incomplete portion in the arrangement of tubular graphene layers can be confirmed based on the presence of the D-band. The defective carbon fibers at this step, for example, exhibit a considerably large intensity ratio R of the D-band to the G-

band($I_{1360}/I_{1580} = I_D/I_G$).

As described above, the defective carbon fiber aggregate obtained by the reactions in the reactor 1 has an incomplete tubular multi-layered structure and contains much impurity and, therefore, is introduced into the next step of heat treatment after having been taken out from the fiber recovery chamber 13.

Step of heat treatment.

The step of heat treatment is executed by introducing the aggregate of the above defective carbon fibers (hereinafter often simply called "D-carbon fibers") into the reactor formed by using heat-resistant ceramics or the like, and heat-treating the D-carbon fibers at a high temperature in the presence of an inert gas such as nitrogen.
In executing the heat treatment, it is allowable to feed into the reactor a reducing gas such as hydrogen gas or carbon monoxide gas together with the inert gas in order to reliably prevent oxidation or the like.

The above heat treatment is executed in two steps of firing at a low temperature and firing at a high temperature. That is, the heat treatment (low-temperature firing) of the first step is conducted at a temperature of 800 to 1200°C which is lower than the temperature of the heat treatment (high-temperature firing) of the second step. Through the heat treatments at such temperatures, the unreacted ingredient materials and tar component contained in the D-carbon fibers are removed by volatilization.
The heat treatment at the first step is conducted, usually, by maintaining the D-carbon fibers in the above temperature range for a period of not shorter than 10 minutes and, specifically, for about 10 to about 30 minutes though the conditions may vary to some extent depending upon the amount of treatment.

The heat treatment (high-temperature firing) of the second step that follows the heat treatment of the first step is executed in a temperature range of from 2, 000 to 3, 000°C which is higher than the temperature of the heat treatment of the first step. Through the heat treatment at such a high temperature, the catalyst metal (Fe) contained in the D-carbon fibers is removed and, at the same time, the patch layers are converted into tubular graphene layers.
Namely, as shown in Fig. 7, the carbon atoms forming the outer patch layers are recrystallized, and tubular graphene layers (3) are secondarily formed on the outer circumference of the inner graphene layers (2) that have been formed already defining the hollow space (1). Thus, there is obtained the vapor-grown carbon fiber aggregate of the invention having two or more tubular graphene layers, and the central portions thereof being hollow in cross section of the fibers.

The heat treatment of the second step is conducted for a relatively long period of time, e.g., for not shorter than 5 minutes and, specifically, for about 20 to about 60 minutes to convert the patch layers into the tubular graphene layers by recrystallization.

<Vapor-grown carbon fiber aggregate >

In the vapor-grown carbon fiber aggregate of the invention having the structure shown in Fig. 7, the inner graphene layer defining the hollow space of fibers is formed by the catalytic reaction in the first reaction region (region (C)) in the reactor 1. The inner graphene layer possessed by the D-carbon fibers shown in Fig. 6 still remains in the vapor-grown carbon fiber aggregate of the invention. Accordingly, the vapor-grown carbon fiber aggregate of the present invention has substantially the same basic structure as the D-carbon fibers except that it contains no catalyst metal (Fe) and that the patch layers have been converted into the graphene layers.

For example, carbon atoms forming patch layers of an irregular structure are the ones that are rearranged on the inner graphene layer (2) formed in the first reaction region. Therefore, the vapor-grown carbon fibers have a structure in which two or more tubular graphene layers are overlapped one upon the other concentrically, each tubular graphene layer being formed in parallel with the fiber axis (center axis of hollow space (1)).
In the present invention, the graphene layers constituting the carbon fibers are "in parallel with" the fiber axis. "In parallel with " stands for that the C-axis of graphene forms an angle of 0 to less than 15° relative to the center line of the hollow structure of the carbon fibers.

The average fiber length of the vapor-grown carbon fibers is from several microns to several tens of microns lying nearly in the same range as that of the D-carbon fibers of Fig. 6. This is because, the inner graphene layers defining the hollow space of fibers remain as they are formed in the first reaction region in the reactor 1.

In the vapor-grown carbon fibers of the invention, further, the outer irregular patch layers are converted into the regular tubular graphene layers greatly improving the structural defect. That is, the intensity ratio R of the D-band to the G-band as measured by the Raman spectrometry is very smaller than that of the above-mentioned D-carbon fibers, and is, usually, not more than 0.2 and, specifically, not more than 0.1.

In the thus obtained vapor-grown carbon fiber aggregate free of structural defect, the carbon fibers have an average outer fiber diameter in a range of from 10 nm to 300 nm, preferably, from 50 to 300 nm and, more preferably, from 90 nm to 300 nm. If the average outer fiber diameter becomes too small, the specific surface area of the carbon fibers becomes great. For example, if the average outer fiber diameter is smaller than 10 nm, the BET specific surface area becomes not smaller than about 100 m$^2$/g. As a result, the fiber aggregate becomes highly cohesive and difficult to handle. For instance, it becomes difficult to homogeneously disperse the fiber aggregate in various kinds of matrixes. If the average outer fiber diameter exceeds 300 nm, on the other hand, the BET specific surface area becomes as very small as about 10 m$^2$/g or less. As a result, if the carbon fibers are to be added to, for example, a resin matrix, then the amount of addition thereof must be considerably large to obtain a good electric conductivity, impairing properties of the resin forming matrix and driving up the cost.

In the present invention, the vapor-grown carbon fiber aggregate has a BET specific surface area of from 10 to 60 m$^2$/g which is particularly preferred from the standpoint of cohesive property. Most desirably, therefore, the vapor-grown carbon fiber aggregate has such an average outer fiber diameter as to have the above specific surface area.

Further, the greatest feature of the vapor-grown carbon fiber aggregate of the present invention is that the proportion of the main fibers is very large, wherein the main fibers have a hollow diameter (2 to 20 nm) and a hollow diameter/outer fiber diameter ratio (1.4 to 20%) lying in very limited ranges. Concretely, not less than 70%, specifically, not less than 80% and, most desirably, not less than 95% of the whole number of the carbon fibers forming the aggregate are the main fibers. The fact that the proportion of the main fibers which have hollow diameters and hollow diameter/ outer fiber diameter ratios lying in narrow ranges is very large, means that the fiber aggregate has a very small unevenness in the structure and, therefore, has stable properties lending itself well for being dispersed in various kinds of matrixes. Here, the carbon fiber aggregate of the present invention contains much main fibers. This is because, as described already, catalyst particles (Fe particles) having little unevenness in the size are formed in growing the graphene layers with the catalyst particles as starting points by thermally decomposing the carbon source by the reaction in the reactor 1.

Further, a very large proportion of the carbon fiber aggregate of the present invention comprises the main fibers and, therefore, its properties are dominated by the main fibers. It is, therefore, very important that the main fibers have a hollow diameter of from 2 to 20 nm and a hollow diameter/outer fiber diameter ratio of from 1.4 to 20%.

For example, if the hollow diameter is smaller than the above range, then it becomes difficult to stably form the corresponding iron catalyst particles. If the hollow diameter is larger than the above range, the matrix material infiltrates into hollow spaces in the fibers through the cut ends (openings) of the fibers that is formed when the carbon fibers are dispersed in the matrix. As a result, properties of the matrix are deteriorated.

Further, the hollow diameter/outer fiber diameter ratio is correlated to the number of the graphene layers constituting the carbon fibers. The smaller the ratio, the larger the number of the graphene layers forming the carbon fibers, and the carbon fibers exhibit improved dynamic characteristics. If the ratio is smaller than 1.4%, however, the carbon fibers possess very small hollow diameters or extremely thick outer fiber diameters. If the hollow diameters are very small, the production thereof becomes difficult as described above. If the outer fiber diameters are extremely thick, the carbon fibers must be dispersed in large amounts in the resin matrix to form electrically conducting paths; i.e., greatly decreased function is obtained for imparting electric conductivity.

Further, if the hollow diameter/outer fiber diameter ratio exceeds 20%, the hollow diameter becomes unnecessarily large. As a result, the matrix material infiltrates into hollow spaces in the fibers through the cut ends (openings) of the fibers formed at the time of dispersion, and properties of the matrix are deteriorated.

The carbon fiber aggregate of the present invention is adjusted for its average diameter into a suitable size by using a grinder, and then, is used for a variety of applications. Here, in order to avoid an increase in the bulk density and to maintain the bulk density at a low value of, for example, not larger than 0.02 g/cm$^3$, it is desired to use an air grinder but not to use a grinder such as ball mill that exerts a large shearing force.

EXAMPLES

The invention will now be described in further detail by way of Examples to which only, however, the invention is in no way limited.

Described below are the method of measuring properties of the vapor-grown carbon fibers and the reactor used for the production.

<Outer diameter and hollow diameter of carbon fibers>

The outer fiber diameter and hollow diameter of the carbon fibers were measured relying on the TEM photograph of the carbon fibers.

That is, the obtained carbon fiber aggregate was observed and photographed by using the TEM of a magnifying power of 80, 000 to 150,000, and the photograph thereof was processed by using an image analysis software (WinROOF manufactured byMITANI CORPORATION). A carbon fiber in the image after processed was measured for its outer fiber diameter and hollow diameter at three points, respectively, perpendicularly to the axial direction of the fiber, and average values thereof were regarded as the outer fiber diameter and the hollow diameter of the carbon fibers. The ratio of the hollow diameter and the outer fiber diameter was also found.

Only those carbon fibers clearly showing the contours were measured. The measurement was taken from all of the carbon fibers (about 60 to about 100 carbon fibers) that could be measured in the TEM photograph, and the average values obtained therefrom were regarded to be the average outer fiber diameter and the average hollow diameter of the carbon fiber aggregate.

<Average diameter of the carbon fiber aggregate >

A SEM photograph was taken with a magnifying power of 50 to 300, and the carbon fiber aggregate was measured for its average diameter relying on the SEM photograph. That is, the contour of the aggregate observed in the SEM photograph was traced by using the image analysis software (WinROOF manufactured by MITANI CORPORATION), and the area inside the contour was found to calculate the equivalent circle diameter. Aggregates (about 200 aggregates) in a total of three visual fields were measured and calculated to find an average value of the equivalent circle diameter, and the average value thereof was regarded as an average diameter of the carbon fiber aggregate. The aggregates of which the contours were unclear were not measured.

<Measurement of bulk density>

1.00Gram of powder sample of the carbon fibers was put into a transparent cylinder having an inner diameter of 70 mm to which a dispersing plate attaching, and an amount of 1.30 L air with a pressure of 0.1 Mpa was blown from the lower side of the dispersing plate to blow up the powder which was then allowed to settle naturally. After blown up 5 times, the powder layer that has settled was measured for its height. The measurement of the height was taken at 6 places, and the bulk density was calculated from the average value of 6 places.

<Raman spectrometry>

By using LabRam 800 manufactured by HORIBA, Ltd., the intensity ratio R ($I_D/I_G$) was measured with an argon laser beam of a wavelength of 514 nm.

<X-ray diffraction>

By using a powder X-ray diffractometer (JDX3532 manufactured by JEOL Ltd.), the 002-plane spacing of the carbon fiber was measured. The measurement was taken in compliance with the method of the Japan Society for Promotion of Science (Latest Technology for Experimenting with Carbon Materials (Analysis) edited by THE CARBON SOCIETY OF JAPAN) by using a K$\alpha$-ray generated by using a Cu-bulb at 40 kV, 30 mA. A silicon powder was also used as an internal standard.
The 002-plane spacing corresponds to a distance between the two neighboring graphenes.

<TG combustion temperature>

By using the TG-DTA manufactured by Mac Science Co. , about 10 mg of the carbon fiber was weighed, put into an alumina crucible, heated at a rate of 10°C/min while flowing the air at a flow rate of 0.1 L/min, and was measured for its behavior of burning. TG represents an ignition loss during the combustion and DTA represents an exothermic peak. Therefore, the top position of the exothermic peak was defined to be a TG combustion temperature.
<BET specific surface area>
In compliance with the principle of measurement of the continuous fluidized gas adsorption method (BET-one point method), a measuring cell filled with about 50 mg of a carbon fiber powder was set in a continuous fluidized specific surface meter (SA-9603 manufactured by HORIBA, Ltd), and the BET specific surface area was measured in liquid nitrogen.

<Electric resistance of the powder and restorable property >

1. 00 Gram of the carbon fiber powder was weighed, put into a resin dies (having inner sizes of 40 mm long, 10 mm wide, 80 mm high) and was compressed therein so that the density of carbon fiber in the dies was 0.8 g/cm$^3$. A constant current was flown into the dies based on the four-terminal method, and a voltage at this moment was measured to calculate the resistance of the powder. By the same method, the resistance of the powder was also measured when the carbon fiber density in the dies was 0.9 g/cm$^3$.
After having measured the resistance of the powder with the density of 0.9 g/cm$^3$, the pressure to the carbon fiber in the dies was decompressed, and the density of the carbon fiber after restoration was measured.

<Reactor>

For producing the vapor-grown carbon fiber aggregates, a reactor was used in Examples and Comparative Examples, which has a structure shown in Fig. 1 (and Fig. 5) with a = 100 mm, b = 165 mm, c = 325 mm, d = 320 mm, e = 110 mm and f = 2000 mm.
In the following experiments, the temperatures were measured by using a thermocouple, and represent temperatures measured at the following portions.

Throw-in temperature:

It is the temperature at the central portion of the inlet port 9b of the introduction nozzle 9 (in the end of the gas introduction pipe 7).

Temperature in the region (A):

It is the reactor temperature at the central portion near the discharge port 9a of the introduction nozzle 9 in the region (A). The thermocouple was inserted along the center axis of the reactor 1 (introduction nozzle 9).

Temperature in the region (B):

It is the reactor temperature at the central portion in the region (B). The thermocouple was inserted along the center axis of the reactor 1 (introduction nozzle 9) to measure the temperature at an intermediate portion between the discharge port 9a of the introduction nozzle 9 and the lower end of the gas flow-adjusting member 21.

Temperature in the region (C):

It is the temperature on the reactor wall. The temperature was measured by making the thermocouple contact with the wall of the straight body portion 11 corresponding to the central portion of the upper heater 17a in the direction of height thereof.

Temperature in the region (D):

It is the temperature on the reactor wall. The temperature was measured by making the thermocouple contact with the wall of the straight body portion 11 corresponding to the central portion of the lower heater 17b in the direction of height thereof.

<Example 1>

As the hydrocarbon source, there were used toluene, benzene and methane at the following mol ratios.

$$\text{toluene/benzene (mol ratio) = 1.73}$$

$$\text{toluene/methane (mol ratio) = 0.19}$$

Further, ferrocene was used as the catalyst source and thiophene was used as the promotor source in amounts as described below per toluene.
ferrocene (catalyst source): 8.0 mass% (per toluene)
thiophene (promotor source): 1.0 mass% (per toluene)
Further, as the carrier gas, a hydrogen gas was mixed at a flow rate of 10500 (N/min/m$^2$) into the carbon source gas containing toluene, benzene and methane at the above ratios to thereby prepare an ingredient gas. The ingredient gas was fed into the reactor 1 (introduction nozzle 9) in such an amount that the flow rate per the reactor sectional area was 811.3 g/min/m$^2$ and that the temperature of the ingredient gas (throw-in temperature) at the inlet port 9b of the introduction nozzle 9 was 400°C.
Here, while the ingredient gas was fed into the reactor 1 under the above-mentioned conditions, the flow rate of the cooling gas fed into the cooling jacket of the introduction nozzle 9 was adjusted and the outputs of the heaters 17a and 17b on the outer surface of the straight body portion 11 were adjusted to set the temperatures in various regions in the reactor 1 (straight body portion 11) as follows:

| | |
|---|---|
| region (A) | 420°C |
| region (B) | 680°C |
| region (C) | 815°C |
| region (D) | 1300°C |

Upon passing the ingredient gas through the above regions (A) to (D), there was obtained an aggregate of D-carbon fibers (primary product) having structural defect. The yield was 61.1%.

The obtained aggregate of D-carbon fibers was measured for its average diameter (equivalent circle diameter), BET specific surface area, average outer fiber diameter (and standard deviation), and average hollow diameter of fibers (and standard deviation). Table 1 shows the results thereof together with the production conditions.

Table 1 also shows the proportion of the main fibers in the aggregate that have hollow diameters of 2 to 20 nm and hollow diameter/outer fiber diameter ratio of 1.4 to 20%.

Next, the thus obtained aggregate of D-carbon fibers was taken out from the reactor, introduced into a heat-treating furnace where it was fired at a low temperature of 900°C in an argon atmosphere (for 20 minutes) followed by firing at a high temperature of 2600°C (for 20 minutes). The obtained heat-treated product was ground by using an air grinder revolving at 5,000 rpm to obtain a desired vapor-grown carbon fiber aggregate free of structural defect.

Like the aggregate of D-carbon fibers, the obtained vapor-grown carbon fibers were measured for their average diameter (equivalent circle diameter), BET specific surface area, average outer fiber diameter (and standard deviation), average hollow diameter of fibers (and standard deviation) and proportion of the main fibers. Table 2 shows the results thereof together with the heat-treating conditions.

In conducting the heat treatment, further, the fibers fired at a low temperature and the fibers fired at a high temperature were measured by the Raman spectroscopy for their intensity ratio R ($I_D/I_G$) of D-band and G-band to be about 1.0 after the firing at a low temperature and 0.089 after the firing at a high temperature. This fact tells that the outermost layer was recrystallized by the firing at a high temperature and formed a tubular graphene layer free of structural defect.

The obtained vapor-grown carbon fibers were, further, measured for their bulk density, TG combustion temperature, powder resistance, and density after the load was no longer exerted (density after restoration). The results were as shown in Table 3.

<Examples 2 to 4 and Comparative Example 1>

D-carbon fiber aggregates (primary products) were produced in quite the same manner as in Example 1 by using the ingredient gases of the compositions and under the production conditions shown in Table 1, and were measured for their properties to obtain the results as shown in Table 1. Here, Comparative Example 1 used only toluene as the carbon source using, however, neither methane nor benzene.

The D-carbon fiber aggregates obtained above were fired at a low temperature of 900°C and at a high temperature of 2600°C in the argon atmosphere like in Example 1 to obtain vapor-grown carbon fiber aggregates (secondary products) free of structural defect.

The aggregates were measured for their properties like in Example 1. The results were as shown in Tables 2 and 3.

Table 1

| <Primary products> | | | | | |
|---|---|---|---|---|---|
| Items | Ex. 1 | Ex. 2 | Ex. 3 | Ex. 4 | Comp. Ex. 1 |
| Tol/Ben (mol ratio) | 1.73 | 8.76 | 15.26 | 11.52 | - |
| Tol/Met (mol ratio) | 0.19 | 0.31 | 0.43 | 0.59 | - |
| Ferro/Tol (mass%) | 8.0 | 4.0 | 8.0 | 2.0 | 8.0 |
| Thio/Tol (mass%) | 1.0 | 1.0 | 1.0 | 1.0 | 3.0 |
| $H_2$ gass (NL/min/m$^2$) | 10500 | 9500 | 9500 | 7100 | 10500 |
| Ingredient gas (g/min/m$^2$) | 811.3 | 846.9 | 1158.9 | 1235.4 | 1184.4 |
| Throw-in temp (°C) | 400 | 400 | 400 | 400 | 400 |

(continued)

| <Primary products> | | | | | |
|---|---|---|---|---|---|
| Items | Ex. 1 | Ex. 2 | Ex. 3 | Ex. 4 | Comp. Ex. 1 |
| Region (A)/°C | 420 | 418 | 412 | 415 | 415 |
| Region (B)/°C | 680 | 680 | 682 | 690 | 685 |
| Region (C)/°C | 815 | 825 | 836 | 880 | 820 |
| Region (D)/°C | 1300 | 1300 | 1300 | 1300 | 1300 |
| Yield (%) | 61.1 | 72.2 | 75.6 | 76.1 | 55.6 |
| Aggregrate average diameter ($\mu$m) | 89.2 | 65.8 | 50.2 | 46.3 | 48.8 |
| BET specific surface area ($m^2$/g) | 32 | 27 | 23 | 15 | 31 |
| Ave. out dia (nm) | 20.3 | 58.4 | 127.3 | 187.5 | 76.9 |
| Standard deviation (nm) | 8.3 | 18.1 | 27.0 | 44.4 | 24.8 |
| Average hollow diameter (nm) | 4.4 | 5.1 | 8.1 | 7.4 | 24.1 |
| $X^1/X^2$ (%) | 14.8 | 9.6 | 6.6 | 4.0 | 33.5 |
| Proportion of main fibers (%) | 78.3 | 98.2 | 100.0 | 100.0 | 12.9 |
| Tol: toluene, Ben: benzene, Met: methane, Ferro: ferrocene, Thio: thiophene, $X^1/X^2$: hollow diameter/outer fiber diameter | | | | | |

Table 2

| <Secondary products> | | | | | |
|---|---|---|---|---|---|
| Items | Ex. 1 | Ex. 2 | Ex. 3 | Ex. 4 | Comp. Ex. 1 |
| Low-temp firing (°C) | 900 | 900 | 900 | 900 | 900 |
| Hi-temp firing (°C) | 2600 | 2600 | 2600 | 2600 | 2600 |
| Aggregate average diameter ($\mu$m) | 75.8 | 58.1 | 45.1 | 40.2 | 42.8 |
| BET specific surface area ($m^2$/g) | 34 | 28 | 25 | 16 | 37 |
| Ave. out dia (nm) | 19.6 | 55.8 | 96.7 | 155.2 | 50.9 |
| Standard deviation (nm) | 7.6 | 10.3 | 26.9 | 38.4 | 15.1 |
| Average hollow diameter (nm) | 4.6 | 5.9 | 9.0 | 5.7 | 12.0 |
| $X^1/X^2$ (%) | 15.8 | 10.9 | 9.9 | 3.8 | 23.4 |
| Proportion of main fibers (%) | 73.0 | 98.7 | 97.1 | 100.0 | 44.4 |
| $X^1/X^2$: hollow diameter/outer fiber diameter | | | | | |

The vapor-grown carbon fiber aggregates (secondary products) obtained in Examples 1 to 4 possessed average outer fiber diameters of 19.6 nm, 55.8 nm, 96.7 nm and 155.2 nm, respectively. The contents of the main fibers having the hollow diameter of 2 to 20nm and the hollow diameter/outer fiber diameter ratio of 1.4 to 20% were not less than 70% for all examples, and tended to increase with an increase in the average outer fiber diameter.

On the other hand, the vapor-grown carbon fiber aggregate (secondary product) obtained in Comparative Example 1 possessed an average outer fiber diameter of 50.9 nm. But the contents of the main fibers was 44.4%. The carbon fiber aggregate of Comparative Example 1 possessed an average outer fiber diameter comparable to that of Example 2 but possessed an average hollow diameter and an average hollow diameter/outer fiber diameter ratio which were very larger than those of Example 2.

From the above results, it is considered that when toluene only is used as the ingredient carbon source like in the Comparative Example 1, it is unable to efficiently form the main fibers having relatively small and aligned hollow diameters due to the problems relating to the balance • timing on the formation of the catalyst metal particles (Fe particles) and the reaction caused by the catalyst metal particles which the carbon fibers extend in the axial direction of the fibers despite that the same production apparatus is used.

In Examples 1 to 4 in which toluene, benzene and methane in the ingredient hydrocarbons are suitably adjusted, on the other hand, it is considered that the catalyst metal particles are formed having small and even particle diameters and then the reaction enabling the carbon fibers to extend takes place.

Table 3

| <Secondary products> | | | | | |
|---|---|---|---|---|---|
| Properties of C fiber aggregate | Ex. 1 | Ex. 2 | Ex. 3 | Ex. 4 | Comp. Ex. 1 |
| Bulk density (g/cm$^3$) | 0.0044 | 0.0050 | 0.0059 | 0.0057 | 0.0081 |
| Intensity ratio R($I_D/I_G$) | 0.089 | 0.090 | 0.085 | 0.095 | 0.069 |
| TG combustion temp. (°C) | 752 | 780 | 785 | 827 | 789 |
| (002)-plane spacing (nm) | 0.3396 | 0.3395 | 0.33932 | 0.33900 | 0.3400 |
| Powder resistance (at 0.8 g/cm$^3$) ($\Omega \cdot$cm) | 0.0137 | 0.0120 | 0.0134 | 0.0122 | 0.0413 |
| Powder resistance (at 0.9 g/cm$^3$) ($\Omega \cdot$cm) | 0.0119 | 0.0100 | 0.0116 | 0.0104 | 0.0350 |
| Density after restored (g/cm$^3$) | 0.196 | 0.210 | 0.200 | 0.210 | 0.250 |

It will be understood from the results of Table 3 that the vapor-grown carbon fiber aggregates of Examples 1 to 4 of the invention have good electric conductivity and restorable property.

Industrial Applicability:

The vapor-grown carbon fiber aggregate of the present invention has no structural unevenness and is capable of being dispersed in various materials maintaining stability. Besides, the vapor-grown carbon fiber aggregate of the invention is capable of imparting excellent properties such as electric conductivity and thermal conductivity in an evenly distributed manner and can, therefore, be used in a variety of fields.
Described below are some of the examples of use.

1) Examples that utilize electric conductivity:

Can be mixed into resins and is preferably used as electrically conducting resins and electrically conducting resin molded articles, such as packing materials, gaskets, containers, resistors, electrically conducting fibers, electric wires, adhesives, inks, coating materials, etc.
Similar effects can also be expected from the composite materials obtained by mixing the carbon fiber aggregate into inorganic materials, specifically, into ceramics and metals.

2) Examples that utilize heat conductivity:

Can be added to fuel oils and lubricating oils to improve their heat conductivity.

3) Examples that utilize electromagnetic wave shielding:

Can be mixed into resins and can be favorably used as electromagnetic wave-shielding coating materials and electromagnetic wave-shielding materials.

4) Electrode materials:

The carbon fiber of the invention easily disperses and has a high electric conductivity, a small hollow diameter and a suitably large surface area, and can be used as an electrode material for cells and capacitors. Namely, the cell and the capacitor forming the electrode by using the carbon fiber aggregate of the invention have a large electrode area to which the electrolyte comes in contact assuring a high output density yet realizing stable voltage supply, long life of cells, improved resistance against the environment, and charge and discharge in short periods of time.

5) Lithium ion secondary cell:

The carbon fibers of the invention can also be used as an additive for improving durability and electric conductivity of the electrodes of the lithium ion secondary cells. Specifically, the carbon fibers having a small hollow diameter are capable of decreasing the permeation of electrolyte into the hollow diameter and the adsorption of lithium ions by the inner walls of the hollow carbon fibers, and can be utilized for developing lithium ion secondary cells that feature high charge/discharge efficiency and long life.

6) Examples that utilize physical properties:

To improve the sliding property, the carbon fiber aggregate of the invention can be mixed into resins or metals and can be used for rolls, brake parts, tires, bearings, lubricating materials, gears, pantographs and the like.

By utilizing its properties of small weight and toughness, further, the carbon fiber aggregate of the invention can be used for the electric wires, bodies of domestic appliances, vehicles and aircraft, as well as housings of machinery.

7) Other uses:

Can be, further, used to substitute for the conventional carbon fibers and beads, and can be applied to, for example, switches and vibration-damping materials.

Description of Reference Numerals:

1: reactor
2-1: carbon source tank (methane)
2-2: carbon source tank (benzene)
2-3: carbon source tank (toluene, ferrocene, thiophene)
4: carrier gas tank (hydrogen gas)
6: evaporator
7: gas introduction pipe
9: introduction nozzle
11: straight body portion
13: fiber recovery chamber
15: gas discharge pipe
17a: upper heater
17b: lower heater
19: cooling gas
21: gas flow-adjusting member

**Claims**

1. A vapor-grown carbon fiber aggregate, wherein the carbon fiber has a structure of two or more tubular graphene layers and of which the central portion in cross section of the fiber is hollow, the average outer fiber diameter of said carbon fibers is from 10 to 300 nm, and not less than 70% of the whole number of said carbon fibers have hollow diameters of from 2 to 20 nm and hollow diameter/outer fiber diameter ratios of from 1.4 to 20%.

2. The vapor-grown carbon fiber aggregate according to claim 1, wherein the graphene layers that constitute said carbon fibers are formed in parallel with the axis of the fibers.

3. The vapor-grown carbon fiber aggregate according to claim 1, wherein the average outer fiber diameter of said carbon fibers is from 50 to 300 nm, and not less than 80% of the whole number of said carbon fibers has hollow diameters and hollow diameter/outer fiber diameter ratios in the above-mentioned ranges.

4. The vapor-grown carbon fiber aggregate according to claim 3, wherein the average outer fiber diameter of said carbon fibers is from 90 to 300 nm, and not less than 95% of the whole number of the carbon fibers has hollow diameters and hollow diameter/outer fiber diameter ratios in the above-mentioned ranges.

5. A method of producing the vapor-grown carbon fiber aggregate according to claim 1 comprising steps of:

preparing an ingredient gas by mixing a carbon source, a catalyst source and a promotor into a hydrogen gas, wherein the carbon source contains methane, benzene and toluene, the catalyst source comprises ferrocene and the promotor comprises thiophene;
introducing said ingredient gas into a reactor;
forming a defective carbon fiber aggregate that is formed from patch layers, the patch layers are patchily deposited by thermally decomposed carbon atoms on the outer circumferential surfaces of tubular graphene layers, by introducing said ingredient gas into the reactor passing from a first reaction region to a second reaction region in said reactor, wherein the temperature of said second reaction region is set to be higher than that of said first reaction region; and

taking out said defective carbon fibers from said reactor followed by a heat treatment in an inert gas atmosphere to remove impurities and to convert said patched layers into tubular graphene layers by recrystallization;

wherein said ingredient gas has a toluene/methane mol ratio of from 0.05 to 10, a toluene/benzene mol ratio of from 0.1 to 100, and a hydrogen content of not less than 70% by volume, and contains said ferrocene in an amount of from 1.0 to 10% and said thiophene in an amount of more than 0.5% but not more than 2.0% on the mass basis of toluene;

said ingredient gas is introduced at a temperature of not higher than 400°C into said reactor; and

said first reaction region is set at 700 to 900°C, and said second reaction region is set at 800 to 1300°C on condition that the temperature therein is higher than the temperature in the first reaction region.

6. The method according to claim 5, wherein said defective carbon fiber aggregate is heat-treated through a low-temperature firing at 800 to 1200°C and a high-temperature firing at 2000 to 3000°C following said low-temperature firing.

7. The method according to claim 5, wherein said ingredient gas is introduced into said first reaction region in a turbulently flowing manner.

8. A composite material in which the vapor-grown carbon fiber aggregate of Claim 1 is dispersed in a matrix of at least one material selected from a resin, ceramics and a metal.

Fig. 1

Fig. 2

ATOMS OF
A METAL CATALYST

MOLECULES OF
A HYDROCARBON GAS

Fig. 3

INGREDIENT GAS

9

21

11

17a

# Fig. 4

19 (COOLING GAS)

21

9

(A)

11

17a

(B)

(C)

● ATOMS OF
THE METAL CATALYST

○ MOLECULES OF
THE HYDROCARBON GAS

# Fig. 5

INGREDIENT GAS

19    19

9

(A)

a

21

d

b

e    (B)

11
(UPPER
PORTION)

17a

(C)

f

c

17b

(LOWER PORTION)

Fig. 6

CENTER LINE →

(1)

(2)

(3)

(4)

(1)

(2)

(3)

D-CARBON FIBER
(PRIMARY PRODUCT)

Fig. 7

CENTER LINE

(1)

(2)

(3)

(1)

(2)

(3)

(SECONDARY PRODUCT)

Fig. 8

## INTERNATIONAL SEARCH REPORT

| | International application No. |
| --- | --- |
| | PCT/JP2011/067503 |

A. CLASSIFICATION OF SUBJECT MATTER
*D01F9/127*(2006.01)i, *C01B31/02*(2006.01)i, *C08K7/06*(2006.01)i, *C08L101/00* (2006.01)i

According to International Patent Classification (IPC) or to both national classification and IPC

B. FIELDS SEARCHED

Minimum documentation searched (classification system followed by classification symbols)
D01F9/08-9/32, C01B31/00-31/36, C08K7/06, C08L101/00-101/16

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>A | JP 63-42920 A (Nikkiso Co., Ltd.),<br>24 February 1988 (24.02.1988),<br>claim 1; page 2, lower left column, lines 13 to 15; page 4, lower left column, line 12 to page 5, upper left column, line 7<br>(Family: none) | 1,3-4,8<br>5-7 |
| A | JP 2003-138432 A (Nikkiso Co., Ltd.),<br>14 May 2003 (14.05.2003),<br>paragraphs [0022] to [0057]<br>& JP 2008-63718 A | 1,3-8 |

| | | |
| --- | --- | --- |
| ☒ Further documents are listed in the continuation of Box C. | ☐ See patent family annex. | |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 13 October, 2011 (13.10.11) | 25 October, 2011 (25.10.11) |

| Name and mailing address of the ISA/<br>Japanese Patent Office | Authorized officer |
| --- | --- |
| Facsimile No. | Telephone No. |

Form PCT/ISA/210 (second sheet) (July 2009)

**INTERNATIONAL SEARCH REPORT**

International application No.

PCT/JP2011/067503

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-73930 A  (Showa Denko Kabushiki Kaisha),<br>12 March 2003 (12.03.2003),<br>claims 1, 2, 4<br>& US 2003/0044603 A1<br>claims 1, 2, 4<br>& US 2004/0166048 A1 | 1,3-8 |

Form PCT/ISA/210 (continuation of second sheet) (July 2009)

**INTERNATIONAL SEARCH REPORT**

| International application No. |
|---|
| PCT/JP2011/067503 |

**Box No. II        Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☒ Claims Nos.:  2
because they relate to parts of the international application that do not comply with the prescribed requirements to such an extent that no meaningful international search can be carried out, specifically:
See extra sheet.

3. ☐ Claims Nos.:
because they are dependent claims and are not drafted in accordance with the second and third sentences of Rule 6.4(a).

**Box No. III        Observations where unity of invention is lacking (Continuation of item 3 of first sheet)**

This International Searching Authority found multiple inventions in this international application, as follows:

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**        ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

| INTERNATIONAL SEARCH REPORT | International application No. |
|---|---|
| | PCT/JP2011/067503 |

Continuation of Box No.II-2 of continuation of first sheet(2)

Claim 2 includes the statement "the graphene layers constituting each carbon fiber have been formed parallel to the fiber axis".

Paragraph [0080] in the description includes a statement to the following effect: that the graphene layers "have been formed parallel to the fiber axis" means that the C axis of the graphene has an angle of 0-15°, excluding 15°, with the center line of the hollow structure of the carbon fiber.

Meanwhile, the graphene layers in claim 2 are "tubular" graphene layers as specified in claim 1, which is cited in this claim, and hence the C axis of this graphene is considered to be substantially perpendicular to the center line of the hollow structure of the carbon fiber.

In view of this, the statement "the graphene layers constituting each carbon fiber have been formed parallel to the fiber axis" in claim 2 includes a technical inconsistency.

Therefore, the invention set forth in claim 2 is unclear, and does not comply with the requirement as provided for in PCT Article 6, to such a degree that a meaningful international search can be made.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5165909 A
- JP 3841684 B
- JP 2006176373 A
- JP 2004003092 A